# EUROPEAN PATENT APPLICATION

(11) **EP 2 104 150 A2**
(43) Date of publication of application: **23.09.2009**
(21) Application number: 08075620.8
(22) Date of filing: 10.07.2008
(51) Int. Cl.: H01L 35/32

(54) **Apparatus for generating electric power using thermal energy**

(30) Priority: 20.03.2008 TW 97109852
(71) Applicant: Luo, Chin-Kuang, Taichung City (TW)
(72) Inventor: Luo, Chin-Kuang, Taichung City (TW)
(74) Representative: Patentanwälte Bressel und Partner

(57) **Abstract**

An apparatus for generating electric power using thermal energy includes a thermoelectric semiconductor device (20) having opposite first and second ceramic layers (21, 22) spaced apart from each other, a row of first conductive members (23) attached spacedly to an inner surface (212) of the first ceramic layer (21), a row of second conductive members (24) attached spacedly to an inner surface (222) of the second ceramic layer (22), alternately arranged P-type and N-type semiconductor elements (25, 26) each disposed between the first and second ceramic layers (21, 22) and interconnecting electrically a corresponding first conductive member (23) and a corresponding second conductive member (24), and a heat insulation material (27) filled between the first and second ceramic layers (21,22). The thermoelectric semiconductor device (20) outputs a DC power corresponding to a difference between temperatures of the first and second ceramic layers (21, 22) to a circuit unit (3) so that the circuit unit (3) outputs a voltage output corresponding to the DC power.

## Description

This application claims priority of Taiwanese Application No. 97109852, filed on May 20, 2008.

The invention relates to an apparatus for generating electric power, more particularly to an apparatus for generating electric power using thermal energy.

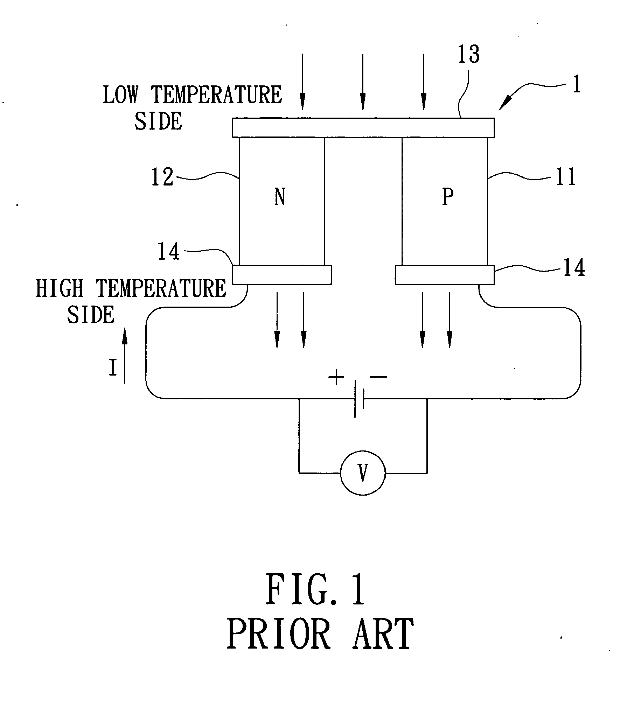

Referring to Figure 1, a conventional thermoelectric semiconductor device 1 for electric generation is shown to include a first metal conductor 13, two second metal conductors 14 spaced apart from each other, a P-type semiconductor element 11 interconnecting electrically the first metal conductor 13 and one of the second metal conductors 14, and an N-type semiconductor element 12 interconnecting electrically the first metal conductor 13 and the other one of the second metal conductors 14 such that the P-type and N-type semiconductor elements 11, 12 are connected electrically to each other in series via the first metal conductor 13, wherein the first metal conductor 13 serves as a low temperature side, and the second metal conductors 14 constitute a high temperature side. As a result of the Seebeck effect, the conventional thermoelectric semiconductor device 1 generates a DC current (I) corresponding to a difference between temperature of the first metal conductor 13 and temperature of the second metal conductors 14.

The following are some of the drawbacks of the conventional thermoelectric semiconductor device 1:
1. The P-type and N-type semiconductor elements 11, 12 are formed by high-pressure pressing fine metal powers, and are soldered respectively to the first and second metal conductors 13, 14 with tin solder having a melting point of 200°C. Thus, the P-type and N-type semiconductor elements 11, 12 are easily broken under a high temperature environment, thereby occurring peeling of the tin solder.
2. Since heat from the second metal conductors 14 is easily transferred to the first metal conductor 13 via air, thereby resulting in a reduced temperature difference between the first metal conductor 13 and the second metal conductors 14.

Therefore, an object of the present invention is to provide an apparatus for generating electric power using thermal energy that can improve the electric-generating efficiency.

According to the present invention, there is provided an apparatus for generating electric power using thermal energy. The apparatus comprises:
a thermoelectric semiconductor unit including at least one thermoelectric semiconductor device that includes
   a first ceramic layer having an outer surface that serves as a low temperature surface adapted to contact a cold source, and an inner surface opposite to the outer surface of the first ceramic layer,
   a second ceramic layer opposite to the first ceramic layer and having an outer surface that serves as a high temperature surface adapted to contact a heat source, and an inner surface opposite to the outer surface of the second ceramic layer, a row of first conductive members attached spacedly to the inner surface of the first ceramic layer, a row of second conductive members attached spacedly to the inner surface of the second ceramic layer,
   a plurality of alternately arranged P-type and N-type semiconductor elements disposed between the first and second ceramic layers, each of the P-type and N-type semiconductor elements interconnecting electrically a corresponding one of the first conductive members and a corresponding one of the second conductive members to form a snakelike structure so that the P-type and N-type semiconductor elements are connected electrically and alternately to each other in series via the first and second conductive members, and
   a heat insulation material filled between the inner surface of the first ceramic layer and the inner surface of the second ceramic layer,
wherein the thermoelectric semiconductor device of the thermoelectric semiconductor unit outputs a DC power in the form of a current corresponding to a difference between temperature of the low temperature surface of the first ceramic layer and temperature of the high temperature surface of the second ceramic layer; and
a circuit unit coupled to the thermoelectric semiconductor unit for receiving the DC power therefrom, and operable so as to output a voltage output corresponding to the DC power.

Other features and advantages of the present invention will become apparent in the following detailed description of the preferred embodiment with reference to the accompanying drawings, of which:
Figure 1 is a schematic view illustrating a conventional thermoelectric semiconductor device;
Figure 2 is a schematic circuit block diagram illustrating the preferred embodiment of an apparatus for generating electric power using thermal energy according to the present invention;
Figure 3 is a schematic view illustrating a thermoelectric semiconductor device of a thermoelectric semiconductor unit of the preferred embodiment;
Figure 4 is a perspective fragmentary view showing the preferred embodiment; and
Figure 5 is a fragmentary schematic sectional view showing the preferred embodiment.

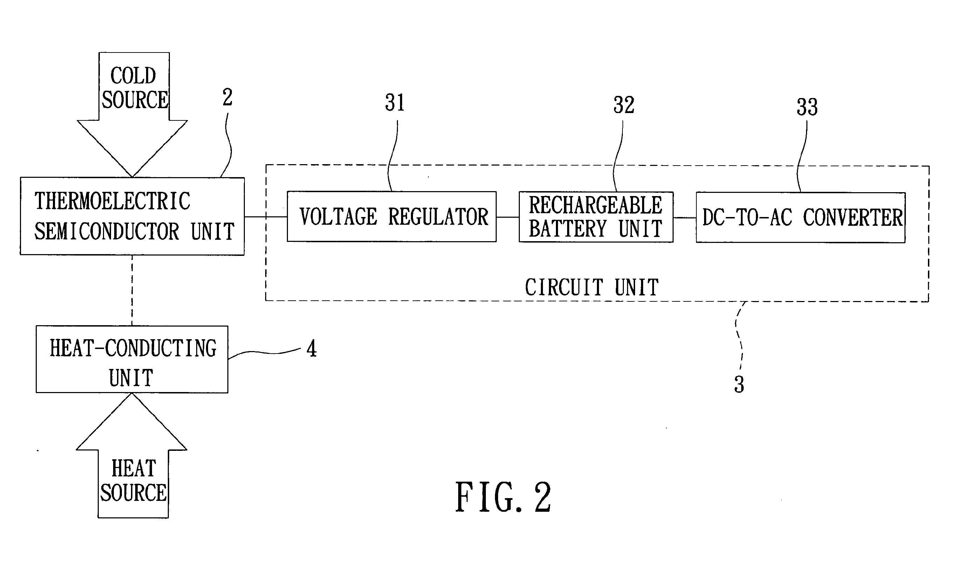

Referring to Figures 2 to 5, the preferred embodiment of an apparatus for generating electric power using thermal energy according to the present invention is shown to include a thermoelectric semiconductor unit 2, a circuit unit 3, and a heat-conducting unit 4.

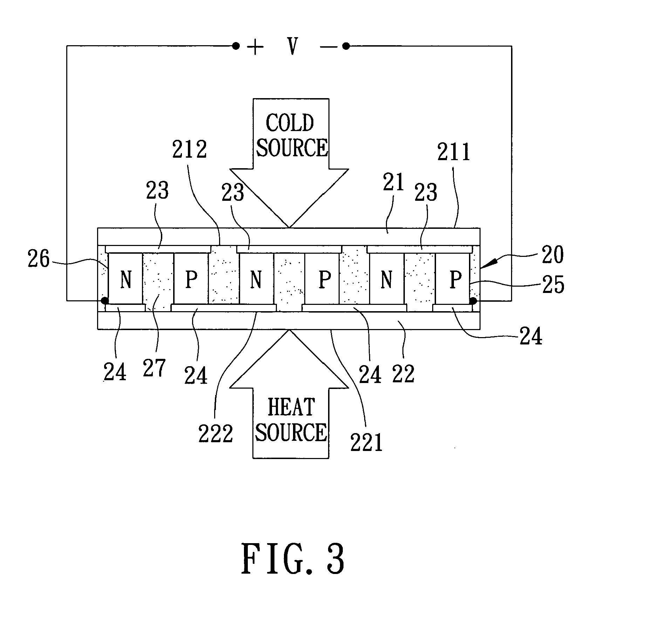

The thermoelectric semiconductor unit 2 includes a plurality of thermoelectric semiconductor devices 20 coupled to each other in series. As shown in Figure 3, each thermoelectric semiconductor device 20 includes a first ceramic layer 21, a second ceramic layer 22, a row of first conductive members 23, a row of second conductive members 24, a plurality of alternately arranged P-type and N-type semiconductor elements 25, 26, and a heat insulation material 27. For each thermoelectric semiconductor device 20, the first ceramic layer 21 has an outer surface that serves as a low temperature surface 211 adapted to contact a cold source, such as stream water, seawater, groundwater, etc., and an inner surface 212 opposite to the low temperature surface 211. The second ceramic layer 22 is opposite to the first ceramic layer 21, and has an outer surface that serves as a high temperature surface 221 adapted to contact a heat source, such as terrestrial heat, hot spring, high-temperature industry exhaust fume, etc., and an inner surface 222 opposite to the high temperature surface 221. The first conductive members 23 are attached spacedly to the inner surface 212 of the first ceramic layer 21. The second conductive members 24 are attached spacedly to the inner surface 222 of the second ceramic layer 22. In this embodiment, each of the first and second conductive members 23, 24 is in the form of a copper foil conductor. The P-type and N-type semiconductor elements 25, 26 are disposed between the first and second ceramic layers 21, 22 . Each of the P-type and N-type semiconductor elements 25, 26 interconnects electrically a corresponding one of the first conductive members 23 and a corresponding one of the second conductive members 24 to form a snakelike structure so that the P-type and N-type semiconductor elements 25, 26 are connected electrically and alternately to each other in series via the first and second conductive members 23, 24. In this embodiment, each of the P-type and N-type semiconductor elements 25, 26 is formed by sintering fine powers of antimony and bismuth, and has opposite end surfaces soldered respectively to the corresponding one of the first conductive members 23 and the corresponding one of the second conductive members 24 with copper solder that has a melting point higher than 500°C. The heat insulation material 27 is filled between the inner surface 212 of the first ceramic layer 21 and the inner surface 222 of the second ceramic layer 22. In this embodiment, the heat insulation material 27 includes an ammonium phosphate compound. Each thermoelectric semiconductor device 20 outputs a DC power in the form of a current corresponding to a difference between temperature of the low temperature surface 211 of the first ceramic layer 21 and temperature of the high temperature surface 221 of the second ceramic layer 22. As a result, the thermoelectric semiconductor unit 2 outputs a sum of the DC powers from the thermoelectric semiconductor devices 20 as a DC input.

The circuit unit 3 is coupled to the thermoelectric semiconductor unit 2 for receiving the DC input therefrom, and is operable so as to output a voltage output corresponding to the DC input. In this embodiment, as shown in Figure 2, the circuit unit 3 includes a voltage regulator 31, a rechargeable battery unit 32, and a DC-to-AC converter 33. The voltage regulator 31 is coupled to the thermoelectric semiconductor unit 2 for receiving and regulating the DC input therefrom. The rechargeable battery unit 32 is coupled to the voltage regulator 31, and is charged by the DC input regulated by the voltage regulator 31 so as to supply a DC voltage. The DC-to-AC converter 33 is coupled to the rechargeable battery unit 32 for converting the DC voltage supplied thereby into an AC voltage, and outputs the AC voltage that serves as the voltage output.

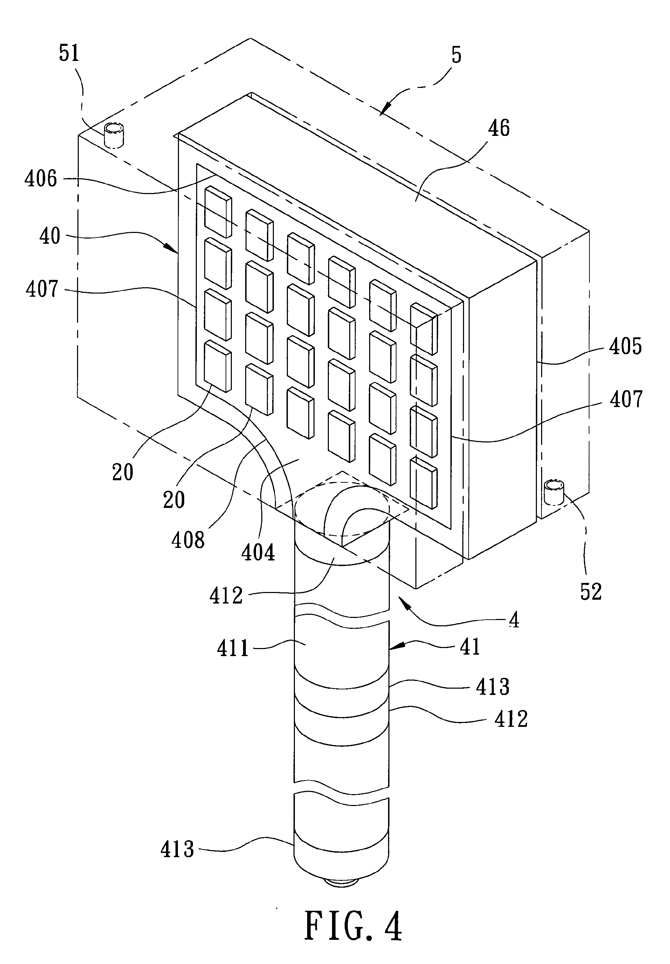

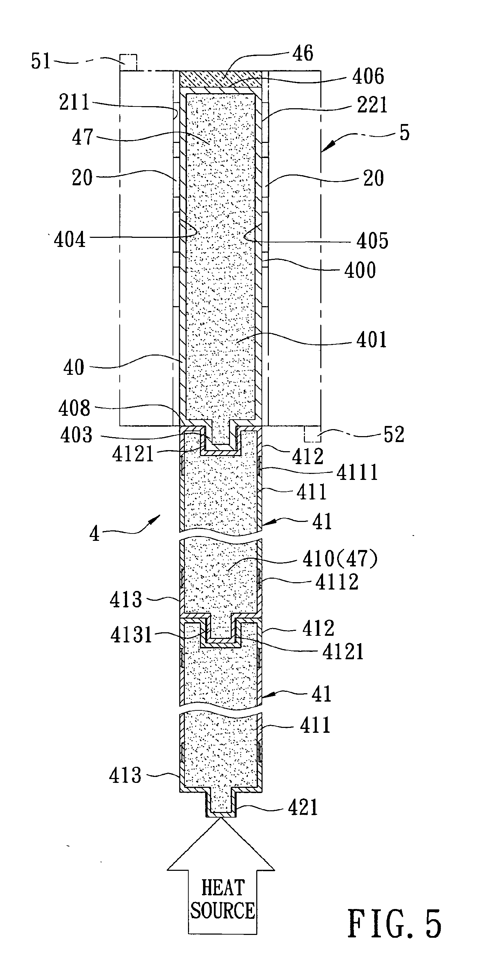

As shown in Figures 4 and 5, the heat-conducting unit 4 is in thermal contact with the high temperature surfaces 221 of the second ceramic layers 22 of the thermoelectric semiconductor devices 20 of the thermoelectric semiconductor unit 2 and is adapted to contact the heat source for transferring heat from the heat source to the high temperature surfaces 221 of the second ceramic layers 22 of the thermoelectric semiconductor devices 20 of the thermoelectric semiconductor unit 2. In this embodiment, the heat conducting unit 4 includes a rectangular hollow heat-conductive body 40, a series of tubular heat-conducting members 41, and a heat insulation frame 46.

The heat-conductive body 40 is configured with a vacuum chamber 401 therein, and has an outer surface 400 that has front and rear surface portions 404, 405, opposite lateral surface portions 407, and top and bottom surface portions 406, 408, wherein the high temperature surfaces 221 of the second ceramic layers 22 of the thermoelectric semiconductor devices 20 of the thermoelectric semiconductor unit 2 are attached to the front and rear surface portions 404, 405. A heat-conductive material 47 is filled in the vacuum chamber 401. In this embodiment, the heat-conductive material 47 is in the form of a volatile solution containing inorganic media, such as manganese (Mn), sodium (Na), beryllium (Be), dichromate, etc., zinc (Zn), magnesium (Mg) and calcium (Ca).

The heat insulation frame 46 covers the top, bottom and lateral surface portions 406, 407, 408 of the outer surface 400 of the heat-conductive body 40.

The tubular heat-conducting members 41 are in thermal contact with each other. One of the tubular heat-conducting members 41, for example, a top one of the tubular heat-conducting members 41 of Figure 5, is in thermal contact with the heat-conductive body 40. Each tubular heat-conducting member 41 is made of copper, iron, high-carbon steel, etc., has a length ranged from 1 m to 10 m, and includes a metal tube body 411, a female cover body 412, a male cover body 413, and the heat-conductive material 47.

For each tubular heat-conducting member 41, the metal tube body 411 has top and bottom ends 4111, 4112. The female cover body 412 is connected threadedly and soldered to the top end 4111 of the metal tube body 411 for covering sealingly the top end 4111 of the metal tube body 411, and is formed with an engaging groove 4121. The male cover body 413 is connected threadedly and soldered to the bottom end 4112 of the metal tube body 411 for covering sealingly the bottom end 4112 of the metal tube body 411, has a plug portion 4131 that engages detachably the engaging groove 4121 in the female cover body 412 of an adjacent one of the tubular heat-conducting members 41, and cooperates with the female cover body 412 and the metal tube body 411 to define an inner accommodating space 410 there among. The heat-conductive material 47 is filled in the inner accommodating space 410.

In this embodiment, the heat-conductive body 40 further has a plug portion 403 extending from the bottom surface portion 408 of the outer surface 400 and engaging detachably the engaging groove 4121 in the female cover body 412 of the top one of the tubular heat-conducting members 41. In this embodiment, each of the plug portion 4131 of the male cover body 413 of each tubular heat-conducting member 41 and the plug portion 403 of the heat-conductive body 49 is in the form of a screw bolt. The engaging groove 4121 in the female cover body 412 of each tubular heat-conducting member 41 is in the form of a blind threaded hole.

Furthermore, a U-shaped heat-conductive water tank 5 has an inlet 51 and an outlet 52, and is disposed around the heat-conductive body 40 so that the water tank 5 is in thermal contact with the low temperature 211 of the thermoelectric semiconductor devices 20 of the thermoelectric semiconductor unit 2. As a result, stream water, seawater or groundwater serving as the cold source can be drawn into the water tank 5 via the inlet 51 to fill the water tank 5, and then flows out of the water tank 5 via the outlet 52 to form a flow cycle, thereby maintaining the low temperature surfaces 211 of the thermoelectric semiconductor devices 20 of the thermoelectric semiconductor unit 2 at a relatively low temperature.

In use, the number of the tubular heat-conducting members 41 depends on a distance between the heat source and the heat-conductive body 40.

In sum, due to the presence of the heat insulation material 27, heat transferred from the second ceramic layer 22 to the first ceramic layer 21 can be minimized, thereby improving the electric-generating efficiency. In addition, since the P-type and N-type semiconductor elements 25, 26 are formed by sintering, structure strength of the P-type and N-type semiconductor elements 25, 26 can be improved. Moreover, the copper foil conductor serving as the first and second conductive members 23, 24 and the copper solder have a melting point much higher than that of the tin solder. Therefore, peeling of the solder incurred in the aforesaid conventional thermoelectric semiconductor device can be avoided.

## Claims

1. An apparatus for generating electric power using thermal energy, **characterized by**:
a thermoelectric semiconductor unit (2) including at least one thermoelectric semiconductor device (20) that includes
a first ceramic layer (21) having an outer surface that serves as a low temperature surface (211) adapted to contact a cold source, and an inner surface (212) opposite to said outer surface of said first ceramic layer (21),
a second ceramic layer (22) opposite to said first ceramic layer (21) and having an outer surface that serves as a high temperature surface (221)adapted to contact a heat source, and an inner surface (222) opposite to said outer surface of said second ceramic layer (22),
a row of first conductive members (23) attached spacedly to said inner surface (212) of said first ceramic layer (21),
a row of second conductive members (24) attached spacedly to said inner surface (222) of said second ceramic layer (22),
a plurality of alternately arranged P-type and N-type semiconductor elements (25, 26) disposed between said first and second ceramic layers (21, 22), each of said P-type and N-type semiconductor elements (25, 26) interconnecting electrically a corresponding one of said first conductive members (23)and a corresponding one of said second conductive members (24) to form a snakelike structure so that said P-type and N-type semiconductor elements (25, 26) are connected electrically and alternately to each other in series via said first and second conductive members (23, 24), and
a heat insulation material (27) filled between said inner surface (212) of said first ceramic layer (21) and said inner surface (222) of said second ceramic layer (22),
wherein said thermoelectric semiconductor device (20) of said thermoelectric semiconductor unit (2) outputs a DC power in the form of a current corresponding to a difference between temperature of said low temperature surface (211) of said first ceramic layer (21) and temperature of said high temperature surface (221) of said second ceramic layer (22); and
a circuit unit (3) coupled to said thermoelectric semiconductor unit (2) for receiving the DC power therefrom, and operable so as to output a voltage output corresponding to the DC power.

2. The apparatus as claimed in Claim 1, **characterized in that** each of said P-type and N-type semiconductor elements (25, 26) of said thermoelectric semiconductor device (20) of said thermoelectric semiconductor unit (2) is formed by sintering fine powers of antimony and bismuth.

3. The apparatus as claimed in Claim 1, **characterized**
**in that:**
each of said first and second conductive members (23, 24) of said thermoelectric semiconductor device (20) is in the form of a copper foil conductor; and
each of said P-type and N-type semiconductor elements (25, 26) of said thermoelectric semiconductor device (20) has opposite end surfaces soldered respectively to the corresponding one of said first conductive members (23) and the corresponding one of said second conductive members (24) with copper solder.

4. The apparatus as claimed in Claim 1, **characterized in that** said circuit unit (3) includes:
a voltage regulator (31) coupled to said thermoelectric semiconductor unit (2) for receiving and regulating the DC power therefrom;
a rechargeable battery unit (32) coupled to said voltage regulator (31)and charged by the DC power regulated by said voltage regulator (31) so as to supply a DC voltage; and
a DC-to-AC converter (33) coupled to said rechargeable battery unit (32) for converting the DC voltage supplied thereby into an AC voltage, and outputting the AC voltage that serves as the voltage output.

5. The apparatus as claimed in Claim 1, further
**characterized by** a heat-conducting unit (4) in thermal contact with said high temperature surface (221) of said second ceramic layer (22) of said thermoelectric semiconductor device (20) and adapted to contact the heat source for transferring heat from the heat source to said high temperature surface (221) of said second ceramic layer (22) of said thermoelectric semiconductor device (20), said heat-conducting unit (4) including a hollow heat-conductive body (40) that has an outer surface (400) to which said high temperature surface (221) of said second ceramic layer (22) of said thermoelectric semiconductor device (20) is attached and that is configured with a vacuum chamber (401), and a heat-conductive material (47) filled in said vacuum chamber (401).

6. The apparatus as claimed in Claim 5, further
**characterized in that:**
said heat-conductive body (40) is rectangular, said outer surface (400) of said heat-conductive body (40) having front and rear surface portions (404, 405), opposite lateral surface portions (407), and top and bottom surface portions (406, 408); and
said thermoelectric semiconductor unit (2) includes a plurality of said thermoelectric semiconductor devices (20) coupled to each other in series and attached to said front and rear surface portions (404, 405) of said outer surface (400) of said heat-conductive body (40).

7. The apparatus as claimed in Claim 6, further **characterized in that** said heat-conducting unit (4) further includes a heat insulation frame (46) for covering said top, bottom and lateral surface portions (406, 407, 408) of said outer surface (400) of said heat-conductive body (40).

8. The apparatus as claimed in Claim 6, further **characterized in that** said heat-conducting unit (4) further includes a series of tubular heat-conducting members (41) in thermal contact with each other, one of said tubular heat-conducting members (41) being in thermal contact with said heat-conductive body (40).

9. The apparatus as claimed in Claim 8, further
**characterized in that:**
each of said tubular heat-conducting members (41) includes
a metal tube body (411) having top and bottom ends (4111, 4112),
a female cover body (412) covering sealingly said top end (4111) of said metal tube body (40) and formed with an engaging groove (4121),
a male cover body (413) covering sealingly said bottom end (4112) of said metal tube body (411), having a plug portion (4131) that engages detachably said engaging groove (4121) in said female cover body (412) of an adjacent one of said tubular heat-conducting members (41), and cooperating with said female cover body (412) and said metal tube body (411) to define an inner accommodating space (410) thereamong, and
a heat-conductive material (47) filled in said inner accommodating space (410); and
said heat-conductive body (40) further has a plug portion (403) extending from said bottom surface portion (408) of saidouter surface (400) and engaging detachably said engaging groove (4121) in said female cover body (412) of said one of said tubular heat-conducting members (41).

10. The apparatus as claimed in Claim 9, further
**characterized in that:**
each of said plug portion (4131) of said male cover body (413) of each of said tubular heat-conducting members (41) and said plug portion (403) of said heat-conductive body (40) is in the form of a screw bolt; and
said engaging groove (4121) in said female cover body (412) of each of said tubular heat-conducting members (41) is in the form of a blind threaded hole.

11. The apparatus as claimed in Claim 1, **characterized in that** said heat insulation material (27) includes an ammonium phosphate compound.
